# EUROPÄISCHE PATENTSCHRIFT

(11) **EP 3 497 534 B1**
(45) Veröffentlichungstag und Bekanntmachung des Hinweises auf die Patenterteilung: **08.01.2020**
(21) Anmeldenummer: 17797254.4
(22) Anmeldetag: 23.10.2017
(51) Int. Cl.: H05B 37/02, G05G 1/02, F21V 8/00

(54) **LICHTSTELLPULT MIT SCHIEBEREGLER**
LIGHT ADJUSTING PANEL WITH WITH REGULATOR
CONSOLE DE RÉGLAGE DE L'ÉCLAIRAGE DOTÉE D'UN CURSEUR

(43) Veröffentlichungstag der Anmeldung: 19.06.2019
(73) Patentinhaber: MA Lighting Technology GmbH, 97297 Waldbüttelbrunn (DE)
(72) Erfinder: ADENAU, Michael, 97082 Würzburg (DE)
(74) Vertreter: advotec.
(86) Internationale Anmeldenummer: PCT/EP2017/076997
(87) Internationale Veröffentlichungsnummer: WO 2019/080991

(56) Entgegenhaltungen:
- EP-A1- 0 935 091
- DE-U1- 8 712 678
- US-A1- 2007 217 211
- US-A1- 2009 244 883
- US-A1- 2016 234 908
- US-B2- 7 784 968

## Beschreibung

Die Erfindung betrifft ein Lichtstellpult mit einem Schieberegler nach dem Oberbegriff des Anspruchs 1.

Gattungsgemäße Lichtstellpulte dienen zur Steuerung von Beleuchtungsanlagen, wie sie beispielsweise in Theatern oder Konzertbühnen zum Einsatz kommen. Diese Beleuchtungsanlagen umfassen regelmäßig eine Vielzahl von Beleuchtungseinrichtungen, beispielweise Bühnenscheinwerfer, wobei sich die Beleuchtungseinrichtungen vielfach auch noch für sich genommen zwischen einer Vielzahl von Beleuchtungszuständen, beispielsweise unterschiedliche Farben, unterscheiden können. Diese unterschiedlichen Beleuchtungszustände werden durch programmierte Parameter im Beleuchtungsprogramm des Lichtstellpults gesteuert. Übliche Beleuchtungsanlagen können dabei bis zu mehrere tausend Beleuchtungseinrichtungen umfassen.

Um derart komplexe Beleuchtungsanlagen steuern zu können, sind die gattungsgemäßen Lichtstellpulte mit einem Digitalprozessor ausgestattet, der eine digitale Daten- und Signalverarbeitung erlaubt. Zur Speicherung der Daten ist weiter ein Digitalspeicher vorgesehen, der es insbesondere ermöglicht, Beleuchtungsprogramme zu archivieren.

Zur Programmierung des Beleuchtungsprogramms bzw. zur Steuerung des Beleuchtungsprogramms während eines Ablaufs müssen vom Bediener Bedienbefehle als Eingabewerte eingegeben werden. Dabei kann es sich beispielsweise um die Auswahl einer bestimmten Beleuchtungseinrichtung bzw. um die Einstellung eines bestimmten Beleuchtungsparameters, beispielsweise einer Leuchtstärke, handeln. Für die Eingabe dieser Bedienbefehle sind an bekannten Lichtstellpulten mechanische Bedienelemente, beispielsweise Taster, Drehregler oder Schieberegler, vorhanden. Die den einzelnen Bedienelementen zugeordneten Bedienbefehle können dabei durch geeignete Menüumschaltung verändert werden, um entsprechend komplexe Beleuchtungsprogramme programmieren und steuern zu können.

Die an den bekannten Lichtstellpulten eingebauten Schieberegler sind dadurch charakterisiert, dass die Eingaben durch lineare Verstellung eines Bedienknopfs durchgeführt werden. Der Bedienknopf ist dabei außerhalb des Gehäuses des Lichtstellpults angeordnet und wird mittels eines Verbindungshebels mit dem im Inneren des Gehäuses vorhandenen Schieberegler verbunden. Der Verbindungshebel erstreckt sich dabei durch einen Schlitz im Gehäuse des Lichtstellpults.

Lichtstellpulte werden häufig in einer dunkel zu haltenden Umgebung, beispielsweise in einem Theaterraum oder einem Konzertsaal, eingesetzt. Fremdlicht zur Beleuchtung des Bedienfelds am Lichtstellpult ist in solchen abzudunkelnden Umgebungen unerwünscht. Um dennoch dem Bediener einen sicheren Zugriff auf verschiedene Bedienelemente zu ermöglichen, sind Lichtstellpulte bekannt, bei denen die verschiedenen Bedienelemente hinterleuchtet werden, wie es beispielsweise in der US 2016/234908 A1 vorgeschlagen wird. So sind Schieberegler bekannt, bei denen der Schlitz im Gehäuse, durch den sich der Verbindungshebel zur Verbindung des Bedienknopfs mit dem Schieberegler erstreckt, entlang seiner Längsachse beleuchtet werden kann. Dies hat zum einen den Vorteil, dass der Bediener die Position des Bedienknopfs erkennen kann und zum anderen die Stellung des Bedienknopfs relativ zur Schlitzlänge erkennbar ist. Aufgrund der linearen Erstreckung des Schlitzes ist bei dessen Hinterleuchtung mittels eines Lichtleitelements bisher ein erheblicher Aufwand erforderlich. So müssen die bekannten Lichtleitelemente zur Beleuchtung des Schlitzes an Schiebereglern von bekannten Lichtstellpulten mit mehreren Lichtquellen, die im Inneren des Gehäuses angeordnet sind, beleuchtet werden. Die bekannten Lichtleitelemente weisen dazu mehrere Lichteintrittsflächen auf, an denen die einzelnen Lichtquellen ihr Licht in das Lichtleitelement einkoppeln, so dass dieses Licht dann den Schlitz an den Lichtaustrittflächen des Lichtleitelements möglichst gleichmäßig beleuchtet.

Ein gattungsgemäßes Lichtleitelement mit mindestens zwei Lichteintrittsflächen wird in der DE 87 12 678 U1 vorgeschlagen, um die Beleuchtung mehrerer Leuchtfelder eines Bedienfelds, beispielsweise von Autoradios oder Maschinen, mit einheitlicher Leuchtdichte zu ermöglichen, so dass nicht jedes Leuchtfeld eines eigenen Lichtleiters bedarf.

In der EP 0 935 091 A1 ist ein gattungsgemäßes stabförmiges Lichtleitelement relativ großer Länge für eine Beleuchtungseinrichtung von Kraftfahrzeugen beschrieben, wobei über die Stirnfläche des Lichtleitelements das Licht, beispielsweise von Leuchtdioden, zur Ausleuchtung des Lichtleitelements über die gesamte Länge eingekoppelt wird. Aufgabe der vorliegenden Erfindung ist es, ein Lichtstellpult mit beleuchteten Schiebereglern vorzuschlagen, die mit einem geringeren baulichen Aufwand eine weitgehend gleichmäßige Beleuchtung des Schlitzes im Gehäuse ermöglichen.

Diese Aufgabe wird durch ein Lichtstellpult nach der Lehre des Anspruchs 1 gelöst.

Vorteilhafte Ausführungsformen der Erfindung sind Gegenstand der Unteransprüche.

Das Lichtleitelement an dem erfindungsgemäßen Lichtstellpult ist zunächst einmal dadurch charakterisiert, dass es nur eine Hauptlichteintrittsfläche aufweist, durch die das gesamte Licht zur Beleuchtung des Schlitzes im Gehäuse des Lichtstellpults eingekoppelt wird. Die Lichtquelle zur Einkopplung des Lichts in das Lichtleitelement ist entsprechend geeignet in der Nähe der Hauptlichteintrittsfläche zu positionieren. Durch die Verwendung nur einer Hauptlichteintrittsfläche, an der mit einer einzigen Lichtquelle das gesamte zur Beleuchtung des Schlitzes notwendige Licht eingekoppelt wird, führt zu einer erheblichen Reduzierung des baulichen Aufwands, da mehrere Lichtquellen mit entsprechenden Lichteintrittsflächen an dem Lichtleitelement, wie sie aus bekannten Lichtstellpulten bekannt sind, entfallen können.

Um dem Benutzer bei der Benutzung des Schiebereglers in abgedunkelten Räumen eine gute Orientierung zu bieten, sind erfindungsgemäß beide Seiten des Schlitzes entlang seiner Längsachse beleuchtet. Um dies zu gewährleisten ist es vorgesehen, dass das Lichtleitelement sich ausgehend von der Hauptlichteintrittsfläche in zwei getrennte Lichtzweige aufteilt, wobei der Schlitz zwischen den beiden Lichtzweigen verläuft. Durch die beiden Lichtzweige wird dann jeweils eine Seite des Schlitzes in gleichmäßiger Weise beleuchtet.

Um trotz der Einkopplung des Lichts an nur einer einzigen Hauptlichteintrittsfläche in das Lichtleitelement eine gleichmäßige Beleuchtung des sich längs erstreckenden Schlitzes zu gewährleisten, werden an dem erfindungsgemäßen Lichtleitelement die Lichtaustrittsflächen von mehreren Lichtaustrittselementen gebildet, die nach Montage des Lichtleitelements entlang des Schlitzes hintereinander angeordnet sind. Erfindungsgemäß ist es dabei vorgesehen, dass die Größe der Lichtaustrittselemente und/oder der Abstand zwischen benachbarten Lichtaustrittselementen mit dem Abstand zur Hauptlichteintrittsfläche korreliert. Dies bedeutet also mit anderen Worten, dass gemäß der ersten Variante die Größe der Lichtaustrittselemente umso größer ist, je weiter das Lichtaustrittselement von der Hauptlichteintrittsfläche entfernt ist. Umgekehrt sind nahe an der Hauptlichteintrittsfläche angeordnete Lichtaustrittselemente entsprechend kleiner. Durch diese Korrelation der Größe der Lichtaustrittselemente zum Abstand zur Hauptlichteintrittsfläche kann die Menge des an den einzelnen Lichtaustrittselementen austretenden Lichts so variiert werden, dass die mit zunehmendem Abstand zur Hauptlichteintrittsfläche abnehmende Leuchtstärke im Lichtleitelement ausgeglichen wird. Bei nahe an der Hauptlichteintrittsfläche angeordneten Lichtaustrittsflächen ist die Leuchtstärke entsprechend stark, so dass entsprechend kleine Lichtaustrittselemente ausreichen, um eine ausreichende Beleuchtung des Schlitzes in diesem Bereich zu gewährleisten. Bei weit von der Hauptlichteintrittsfläche entfernten Lichtaustrittselementen wird dagegen die Größe des Lichtaustrittselements entsprechend vergrößert, um eine gleichgroße Beleuchtung dieses Bereichs entlang des Schlitzes zu gewährleisten.

In gleicher Weise kann neben der Größe der einzelnen Lichtaustrittselemente auch der Abstand zwischen benachbarten Lichtaustrittselementen zur Kompensation der abnehmenden Leuchtstärke eingesetzt werden. So können nahe zur Hauptlichteintrittsfläche angeordnete Lichtaustrittelemente einen relativ großen Abstand aufweisen, wohingegen der Abstand benachbarter Lichtaustrittelemente in großer Entfernung zur Hauptlichteintrittsfläche entsprechend kleiner gewählt wird, um insgesamt eine gleichmäßige Beleuchtung des Schlitzes entlang seiner Längsachse zu gewährleisten.

Um die Befestigung der Lichtquelle, mit der das Licht in das Lichtleitelement eingekoppelt wird, zu erleichtern, ist das Lichtleitelement dadurch charakterisiert, dass das Lichtleitelement zwischen der Hauptlichteintrittsfläche und den beiden Lichtzweigen einen Bogen aufweist. Bei diesem Bogen kann es sich beispielsweise um einen rechtwinkligen Bogen handeln, so dass das Licht, das an der Hauptlichteintrittsfläche eingekoppelt wurde, in diesem Fall um 90° umgelenkt wird.

Auf diese Weise können dann die an den Hauptlichteintrittsflächen anzubringenden Lichtquellen beabstandet zur Innenseite des Gehäuses problemlos angebracht werden.

Welche geometrische Form die einzelnen Lichtaustrittselemente aufweisen, ist grundsätzlich beliebig. Gemäß einer bevorzugten Ausführungsform ist es vorgesehen, dass Lichtaustrittsprismen als Lichtaustrittselemente an dem Lichtleitelement vorhanden sind.

Um eine gleichmäßige Beleuchtung des Schlitzes zu erreichen, kann die Größe der Lichtaustrittselemente mit zunehmendem Abstand zur Hauptlichteintrittsfläche linear größer werden. In diesem Fall ist es dann vorteilhaft für eine gleichmäßige Beleuchtung des Schlitzes, wenn die Lichtaustrittselemente jeweils einen äquidistanten Abstand aufweisen.

Alternativ dazu kann der Abstand zwischen benachbarten Lichtaustrittselementen mit zunehmendem Abstand zur Hauptlichteintrittsfläche linear kleiner werden, wobei die Lichtaustrittselemente selbst jeweils die gleiche Größe aufweisen.

Durch die lineare Variation des Abstands zwischen den benachbarten Lichtaustrittselementen bzw. der linearen Variation der Größe der einzelnen Lichtaustrittselemente kann die im Wesentlichen lineare Abnahme der Leuchtstärke mit zunehmendem Abstand zur Hauptlichteintrittsfläche mit hoher Gleichmäßigkeit ausgeglichen werden.

Besonders kostengünstig kann das Lichtleitelement aus einem Licht leitenden Kunststoff hergestellt sein. Zur Beleuchtung der Lichtleitelemente sind insbesondere LED-Leuchtmittel geeignet.

Eine Ausführungsform der Erfindung ist in den Zeichnungen schematisiert dargestellt und wird nachfolgend beispielhaft erläutert.

Es zeigen:
- **Fig. 1**: ein Lichtstellpult mit mehreren Schiebereglern in perspektivischer Ansicht von vorne;
- **Fig. 2**: fünf Lichtleitelemente zur Beleuchtung von fünf nebeneinanderliegenden Schlitzen von Schiebereglern des Lichtstellpults gemäß Fig. 1 in perspektivischer Ansicht von oben;
- **Fig. 3**: ein Lichtleitelement gemäß Fig. 2 in perspektivischer Ansicht von unten;
- **Fig. 4**: das Lichtleitelement gemäß Fig. 3 in einer vergrößerten Teilansicht.

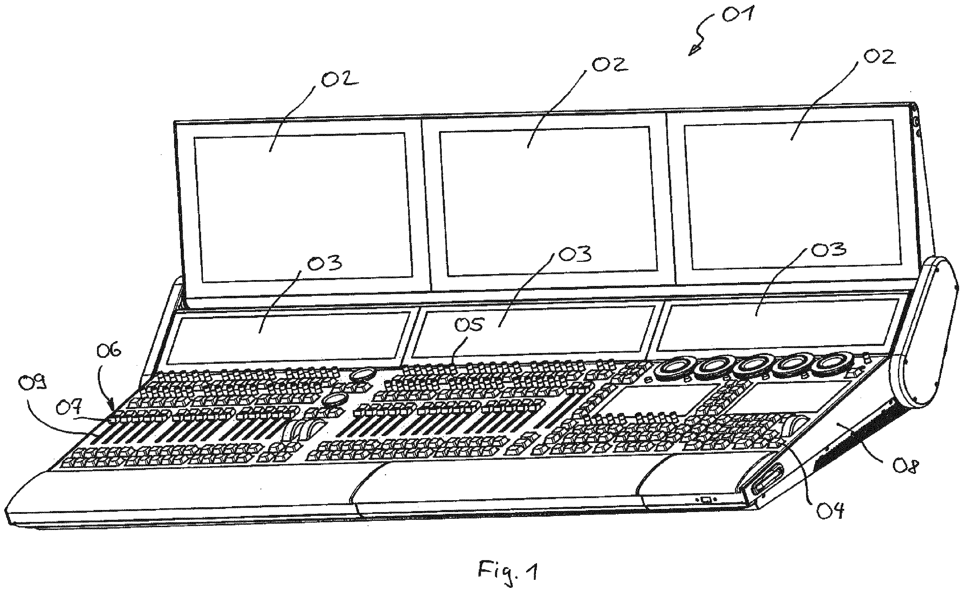

**Fig. 1** zeigt in perspektivischer Ansicht ein erfindungsgemäßes Lichtstellpult 01 zur Programmierung und Steuerung einer Bühnenbeleuchtungsanlage. Das Lichtstellpult 01 ist mit drei Monitoren 02 und drei Monitoren 03 zur Anzeige von diversen Menüs für den Benutzer ausgestattet. Zur Eingabe von Stellbefehlen sind am Lichtstellpult 01 eine Vielzahl von Druckknöpfen 04, Drehreglern 05 und Schiebereglern 06 vorgesehen. Jeder Schieberegler 06 ist dabei mit einem Bedienknopf 07 ausgestattet, der mittels eines in Fig. 1 nicht dargestellten Verbindungshebels mit dem Schieberegler, der sich auf der Innenseite des Gehäuses 08 befindet, verbunden ist. Der Verbindungshebel zwischen Bedienknopf 07 und dem eigentlichen Schieberegler 06 erstreckt sich dabei durch Schlitze 09 im Gehäuse 08. Bei dem in Fig. 1 dargestellten Lichtstellpult 01 werden die Schlitze 09 im Gehäuse 08 mittels nachfolgend noch näher zu erläuternder Lichtleitelemente 10 beleuchtet.

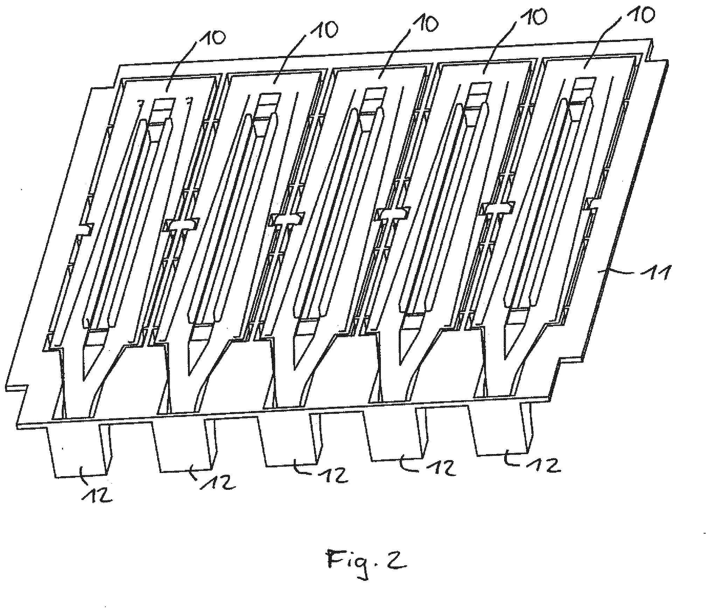

**Fig. 2** zeigt fünf Lichtleitelemente 10, die gemeinsam mittels eines Trägerelements 11 auf der Innenseite des Gehäuses 08 befestigt werden, um fünf nebeneinanderliegende Schlitze 09 zu beleuchten. Das Trägerelement 11 umfasst dabei an seiner Unterseite fünf Fassungen 12, in denen jeweils eine Lichtquelle, nämlich eine LED-Leuchte angeordnet wird, um das für die Beleuchtung der Schlitze 09 notwendige Licht in die Lichtleitelemente 10 einzukoppeln.

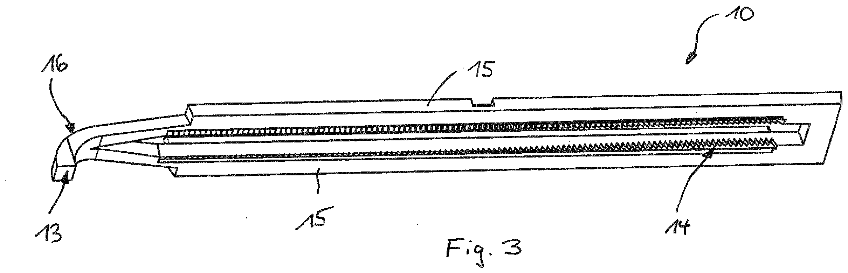

**Fig. 3** zeigt ein Lichtleitelement 10 in perspektivischer Ansicht von unten. Das Lichtleitelement 10 weist eine Hauptlichteintrittsfläche 13 auf, an der das von einer LED-Leuchte erzeugte Licht in das Lichtleitelement 10 eingekoppelt wird. Das Lichtleitelement 10 ist dabei aus einem Licht leitenden Kunststoff hergestellt, und kann das Licht zu den Lichtaustrittselementen 14, die in der Art von Lichtaustrittsprismen ausgebildet sind, weiterleiten. An den Lichtaustrittsprismen tritt das Licht dann wieder aus dem Lichtleitelement 10 aus und beleuchtet somit jeweils eine Seite eines Schlitzes 09 von der Gehäuseinnenseite her. Man erkennt, dass die Lichtaustrittselemente 14 in einer Vielzahl hintereinander entlang des Schlitzes 09 am Lichtleitelement 10 angeordnet sind. Um die mit größer werdendem Abstand zur Hauptlichteintrittsfläche 13 schwächer werdende Leuchtstärke innerhalb des Lichtleitelements 10 auszugleichen, werden die einzelnen Lichtaustrittselemente 14, hier Lichtaustrittsprismen, mit größer werdendem Abstand zur Hauptlichteintrittsfläche 13 immer größer, so dass im Ergebnis an jedem einzelnen Lichtaustrittsprisma in etwa die gleiche Lichtmenge austritt und auf diese Weise eine weitgehend gleichmäßige Beleuchtung der Schlitze 09 realisiert wird.

Um beide Seiten der Schlitze 09 mit einem Lichtleitelement 10 beleuchten zu können, teilt sich das Lichtleitelement 10 ausgehend von der Hauptlichteintrittsfläche in zwei getrennte Lichtleitzweige 15. Um die Lichtquellen innerhalb der Fassungen 12 anordnen zu können, weist das Lichtleitelement 10 zwischen der Hauptlichteintrittsfläche 13 und den sich entlang des Schlitzes 09 erstreckenden Lichtleitzweigen 15 einen Bogen 16 auf, in dem das Licht um circa 90° umgelenkt wird.

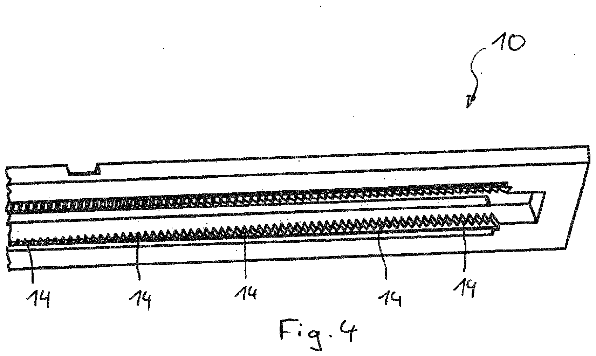

**Fig. 4** zeigt das Lichtleitelement 10 in einem vergrößerten Darstellungsausschnitt. Man erkennt, dass die einzelnen Lichtaustrittselemente 14, die in der Art von Lichtaustrittsprismen ausgebildet sind, umso größer werden, je weiter sie von der Hauptlichteintrittsfläche 13 entfernt sind.

Durch diese Größenänderung wird die sich abschwächende Leuchtstärke innerhalb des Lichtleitelements 10 ausgeglichen, und eine Beleuchtung der Schlitze 09 mit weitgehend gleichmäßiger Leuchtstärke entlang der gesamten Länge der Schlitze 09 realisiert.

## Patentansprüche

1. Lichtstellpult (01) zur Steuerung einer Beleuchtungsanlage, wobei im Lichtstellpult (01) digitale Stellbefehle erzeugt werden, die über Datenverbindungen an die Beleuchtungseinrichtungen der Beleuchtungsanlage übertragen werden können, und wobei das Lichtstellpult (01) zumindest einen Digitalprozessor und zumindest einen Digitalspeicher zur Erzeugung, Verwaltung und Speicherung der digitalen Stellbefehle umfasst, und wobei das Lichtstellpult (01) zumindest eine Anzeigeeinrichtung (02, 03) umfasst, und wobei an der Anzeigeeinrichtung (02, 03) Grafikelemente für den Benutzer grafisch dargestellt werden können, und wobei im Bedienfeld des Lichtstellpults (01) zumindest ein Bedienknopf (07) vorgesehen ist, an dem Eingabewerte vom Benutzer durch lineare Verstellung des Bedienknopfes (07) eingegeben werden können, und wobei im Gehäuse (08) des Lichtstellpults ein Schieberegler (06) vorgesehen ist, und wobei im Gehäuse (08) des Lichtstellpults (01) mindestens ein Schlitz (09) vorgesehen ist,
den ein Verbindungshebel ausgehend vom Inneren des Gehäuses (08) durchgreift und den Bedienknopf (07) mit dem Schieberegler (06) mechanisch verbindet, wobei für den mindestens einen Schlitz jeweils gilt, dass im Gehäuse (08) des Lichtstellpults (01) ein dem Schlitz (09) zugeordnetes Lichtleitelement (10) vorgesehen ist, das sich entlang der Längsachse des Schlitzes (09) erstreckt, und dass im Gehäuse (08) des Lichtstellpults (01) eine Lichtquelle vorgesehen ist, und dass das Lichtleitelement (10) eine Hauptlichteintrittsfläche (13) aufweist, an der Licht von der Lichtquelle in das Lichtleitelement (10) eingekoppelt werden kann, und dass das Lichtleitelement (10) entlang der Längsachse des Schlitzes (09) Lichtaustrittsflächen aufweist, an denen Licht aus dem Lichtleitelement (10) austreten kann, um den Schlitz (09) zu beleuchten,
**dadurch gekennzeichnet, dass** das Licht von der Lichtquelle ausschließlich an der Hauptlichteintrittsfläche (13) in das Lichtleitelement (10) eingekoppelt wird, und dass sich das Lichtleitelement (10) ausgehend von der Hauptlichteintrittsfläche (13) in zwei getrennte Lichtleitzweige (15) aufteilt, dass der Schlitz (09) zwischen den beiden Lichtleitzweigen (15) verläuft, und dass das Lichtleitelement (10) zwischen der Hauptlichteintrittsfläche (13) und den beiden Lichtleitzweigen (15) einen Bogen (16) aufweist, in dem das Licht umgelenkt wird, und dass die Lichtaustrittsflächen des Lichtleitelements (10) von mehreren Lichtaustrittselementen (14) gebildet werden, und dass die Größe des jeweiligen Lichtaustrittselements (14) oder der Abstand zwischen benachbarten Lichtaustrittselementen der mehreren Lichtaustrittselemente (14) mit dem Abstand zur Hauptlichteintrittsfläche (13) korreliert.

2. Lichtstellpult nach Anspruch 1,
**dadurch gekennzeichnet,**
**dass** jedes der mehreren Lichtaustrittselemente (14) in der Art eines Lichtaustrittsprismas ausgebildet ist.

3. Lichtstellpult nach Anspruch 1 oder 2,
**dadurch gekennzeichnet,**
**dass**, wenn die Größe der Lichtaustrittselemente (14) mit dem Abstand zur Hauptlichteinstrittsfläche korreliert, wobei die Grösse mit zunehmendem Abstand zur Hauptlichteintrittsfläche (13) linear größer wird, die benachbarten Lichtaustrittselemente (14) jeweils einen äquidistanten Abstand aufweisen.

4. Lichtstellpult nach Anspruch 1 oder 2,
**dadurch gekennzeichnet, dass**, wenn der Abstand zwischen benachbarten Lichtaustrittselementen (14) mit dem Abstand zur Hauptlichteintrittsfläche korreliert, wobei der Abstand mit zunehmendem Abstand zur Hauptlichteintrittsfläche (13) linear kleiner wird, die mehreren Lichtaustrittselemente (14) jeweils die gleiche Größe aufweisen.

5. Lichtstellpult nach einem der Ansprüche 1 bis 4,
**dadurch gekennzeichnet,**
**dass** das Lichtleitelement (10) aus einem Licht leitenden Kunststoff hergestellt ist.

6. Lichtstellpult nach einem der Ansprüche 1 bis 5,
**dadurch gekennzeichnet,**
**dass** die Lichtquelle zur Beleuchtung des Lichtleitelements (10) als LED-Leuchtmittel ausgebildet ist.

## Claims

1. A lighting control console (01) for controlling a lighting system, digital adjusting commands being generated in the lighting control console (01), said adjusting commands being transmitted to the lighting devices of the lighting system via data links, and said lighting control console (01) comprising at least one digital processor and at least one digital memory for generating, managing and storing the digital adjusting commands, and said lighting control console (01) comprising at least one display device (02, 03), and the display device (02, 03) being able to graphically depict graphic elements for the user, and at least one control knob (07) being provided in the control panel of the lighting control console (01), which control knob (07) allows the user to enter input values by linearly adjusting the control knob (07), and a slide control (06) being provided in the housing (08) of the lighting control console (01), and at least one slit (09) being provided in the housing (08) of the lighting control console (01), said slit being penetrated by a connecting lever originating from the interior of the housing (08) and mechanically connecting the control knob (07) to the slide control (06), wherein the following applies for the at least one slit in each case:
a light conducting element (10) allocated to the slit (09) is provided in the housing (08) of the lighting control console (01), said light guiding element extending along the longitudinal axis of the slit (09), and a light source is provided in the housing (08) of the lighting control console (01), and the light conducting element (10) comprises a main light entry surface (13) at which light from the light source is coupled into the light conducting element (10), and the light conducting element (10) comprises light exit surfaces along the longitudinal axis of the slit (09), light being able to exit from the light conducting element (10) at said light exit surfaces so as to illuminate the slit (09),
**characterised in that**
the light from the light source is coupled into the light conducting element (10) exclusively at the main light entry surface (13), and the light conducting element (10) diverges into two separate light conducting branches (15) starting from the main light entry surface (13), the slit (09) extends between the two light conducting branches (15), and the light conducting element (10) has an arch (16), in which the light is deflected, between the main light entry surface (13) and the two light conducting branches (15), and the light exit surfaces of the light conducting element (10) are formed by several light exit elements (14) and the size of each light exit element (14) or the distance between adjacent light exit elements (14) of the multiple light exit elements (14) corresponds to the distance to the main light entry surface (13).

2. The lighting control console according to claim 1,
**characterised in that**
each of the multiple light exit elements (14) is realised in the manner of a light exit prism.

3. The lighting control console according to claim 1 or 2,
**characterised in that**
the adjacent light exit elements (14) each present an equidistant distance when the size of the light exit elements (14) corresponds to the distance to the main light entry surface, said size linearly increasing as the distance to the main light entry surface (13) increases.

4. The lighting control console according to claim 1 or 2,
**characterised in that**
the multiple light exit elements (14) each present the same size, when the distance between adjacent light exit elements (14) corresponds to the distance to the main light entry surface, said distance linearly decreasing as the distance to the main light entry surface (13) increases.

5. The lighting control console according to one of the claims 1 to 4,
**characterised in that**
the light conducting element (10) is made of a plastic material capable of conducting light.

6. The lighting control console according to one of the claims 1 to 5,
**characterised in that**
the light source for illuminating the light conducting element (10) is realised in the manner of an LED illumination means.

## Revendications

1. Pupitre de commande d'éclairage (01) pour commander un système d'éclairage, des instructions de réglage numériques qui peuvent être transmises aux dispositifs d'éclairage du système d'éclairage par des liaisons de données étant générées dans ledit pupitre de commande d'éclairage (01), et ledit pupitre de commande d'éclairage (01) comprenant au moins un processeur numérique et au moins une mémoire numérique pour générer, gérer et stocker les instructions de réglage numériques, et ledit pupitre de commande d'éclairage (01) comprenant au moins un dispositif d'affichage (02, 03), et des éléments graphiques pouvant être visualisés graphiquement pour l'utilisateur audit dispositif d'affichage (02, 03), et au moins un bouton de manœuvre (07) étant prévu dans le panneau de commande du pupitre de commande d'éclairage (01), les utilisateurs pouvant entrer des valeurs d'entrée audit bouton de manœuvre (07) en ajustant le bouton de manœuvre (07) de manière linéaire, et un curseur (06) étant prévu dans le boîtier (08) du pupitre de commande d'éclairage, et au moins une fente (09) étant prévue dans ledit boîtier (08) du pupitre de commande d'éclairage (01), un levier de liaison, provenant de l'intérieur du boîtier (08), pénétrant ladite fente (09) et mécaniquement reliant le bouton de manœuvre (07) avec le curseur (06), ce qui suit étant toujours applicable pour ladite au moins une fente :
dans le boîtier (08) du pupitre de commande d'éclairage (01), un élément conducteur de lumière (10) est prévu qui est attribué à la fente (09) et qui s'étend le long de l'axe longitudinal de la fente (09), et une source lumineuse est prévue dans le boîtier (08) du pupitre de commande d'éclairage (01), et l'élément conducteur de lumière (10) présente une surface d'entrée de lumière principale (13) à laquelle de la lumière émise par la source lumineuse est couplée dans l'élément conducteur de lumière (10), et l'élément conducteur de lumière (10) présente des surfaces de sortie de lumière le long de l'axe longitudinal de la fente (09) auxquelles la lumière a la possibilité de sortir de l'élément conducteur de lumière (10) pour illuminer la fente (09),
**caractérisé en ce que**
la lumière émise par la source lumineuse est couplée dans l'élément conducteur de lumière (10) exclusivement à la surface d'entrée de lumière principale (13), et **en ce que** l'élément conducteur de lumière (10), provenant de la surface d'entrée de lumière principale (13), se partage en eux branches conductrices de lumière (15) séparées, **en ce que** la fente (09) passe entre les deux branches conductrices de lumière (15), et **en ce que** l'élément conducteur de lumière (10) présente un arc (16) entre la surface d'entrée de lumière principale (13) et les deux branches conductrices de lumière (15) dans lequel la lumière change de direction, et **en ce que** les surfaces de sortie de lumière de l'élément conducteur de lumière (10) sont constituées par plusieurs éléments de sortie de lumière (14), et **en ce que** les dimensions de l'élément de sortie de lumière (14) respectif ou la distance entre des éléments de sortie de lumière adjacents des plusieurs éléments de sortie de lumière (14) sont/est en corrélation avec la distance de la surface d'entrée de lumière principale (13).

2. Pupitre de commande d'éclairage selon la revendication 1,
**caractérisé en ce que**
chacun des plusieurs éléments de sortie de lumière (14) est réalisé à la manière d'un prisme de sortie de lumière.

3. Pupitre de commande d'éclairage selon la revendication 1 ou 2,
**caractérisé en ce que**,
quand les dimensions des éléments de sortie de lumière (14) sont en corrélation avec la distance de la surface d'entrée de lumière principale, lesdites dimensions grandissant linéairement à mesure que la distance de la surface d'entrée de lumière principale (13) croît, les éléments de sortie de lumière (14) adjacents chacun présentent une distance équidistante.

4. Pupitre de commande d'éclairage selon la revendication 1 ou 2,
**caractérisé en ce que**,
quand la distance entre des éléments de sortie de lumière (14) adjacents est en corrélation avec la distance de la surface d'entrée de lumière principale, ladite distance décroissant linéairement à mesure que la distance de la surface d'entrée de lumière principale (13) croît, les plusieurs éléments de sortie de lumière (14) chacun présentent les mêmes dimensions.

5. Pupitre de commande d'éclairage selon l'une quelconque des revendications 1 à 4,
**caractérisé en ce que**
l'élément conducteur de lumière (10) est fabriqué à base d'une matière plastique qui conduit de la lumière.

6. Pupitre de commande d'éclairage selon l'une quelconque des revendications 1 à 5,
**caractérisé en ce que**
la source lumineuse pour illuminer l'élément conducteur de lumière (10) est réalisée comme une diode électroluminescente.
